# EUROPÄISCHE PATENTSCHRIFT

(11) **EP 2 408 949 B1**
(45) Veröffentlichungstag und Bekanntmachung des Hinweises auf die Patenterteilung: **16.01.2013**
(21) Anmeldenummer: 09801427.7
(22) Anmeldetag: 10.12.2009
(51) Int. Cl.: C23C 30/00, F16J 9/26

(54) **VERFAHREN ZUR BESCHICHTUNG EINES GLEITELEMENTS UND GLEITELEMENT, INSBESONDERE KOLBENRING**
METHOD FOR COATING A SLIDING ELEMENT AND SLIDING ELEMENT, IN PARTICULAR A PISTON RING
PROCÉDÉ DE REVÊTEMENT D'UN ÉLÉMENT DE GLISSEMENT ET ÉLÉMENT DE GLISSEMENT, NOTAMMENT SEGMENT DE PISTON

(30) Priorität: 19.03.2009 DE 102009013855
(43) Veröffentlichungstag der Anmeldung: 25.01.2012
(73) Patentinhaber: Federal-Mogul Burscheid GmbH, 51399 Burscheid (DE)
(72) Erfinder: KENNEDY, Marcus, 40479 Düsseldorf (DE)
(74) Vertreter: HOFFMANN EITLE
(86) Internationale Anmeldenummer: PCT/EP2009/066824
(87) Internationale Veröffentlichungsnummer: WO 2010/105710

(56) Entgegenhaltungen:
- DE-C1- 19 708 402
- BARBEZAT G ET AL: "Coating and Materials by Sulzer Metco - Surface Solutions for the Requirements of Tomorrow" SULZER TECHNICAL REVIEW Bd. 4, 2007, Seiten 8-11, XP002568568 Sulzer Metco AG, Wohlen [CH] Gefunden im Internet: URL:http://www.sulzer.com/en/Portaldata/7/ Resources/03_newsmedia/str/2007/2007_4_bar bezat_e.pdf> [gefunden am 2010-02-12]
- DAHOTRE N B ET AL: "Nanocoatings for engine application" SURFACE AND COATINGS TECHNOLOGY, Bd. 194, Nr. 1, 4. Juli 2004 (2004-07-04), Seiten 58-67, XP004749163 ELSEVIER, AMSTERDAM [NL] ISSN: 0257-8972

## Beschreibung

### Technisches Gebiet

Die Erfindung betrifft ein Verfahren zur Beschichtung eines Gleitelements und ein Gleitelement, insbesondere einen Kolbenring. An Gleitelemente, wie zum Beispiel Kolbenringe, wird die Anforderung gestellt, dass sie dauerhaft geringe Reibungsverluste mit sich bringen. Beispielsweise wirkt sich bei Kolbenringen, die als Gleitelemente in Verbrennungsmotoren fungieren, eine Erhöhung der Reibung unmittelbar auf den Kraftstoffverbrauch aus. Ferner wird der Ölverbrauch durch den Zustand der Kolbenringe beeinflusst. Insbesondere ist hierzu die sogenannte Brandspurfestigkeit sowie Ausbruchsfestigkeit zu betrachten, die besonders hoch sein müssen, um dauerhaft die notwendigen Reibungswerte zu realisieren.

### Stand der Technik

Als Vorbenutzungsgegenstände sind Kolbenringe bekannt, die mittels PVD-Verfahren auf Hartstoffbasis, insbesondere Chromnitrid, beschichtet sind. Ferner ist die elektrochemische Deposition von Chromschichten verbunden mit der Einlagerung von A1203- oder Diamantpartikeln bekannt, deren Größe im Mikrometerbereich liegt.

Aus der WO 2007/079834 A1 geht ein DLC(diamond like carbon)-Schichtsystem hervor, das Wolframcarbidausscheidungen in nanokristalliner Form enthalten kann, die während des Abscheideprozesses entstehen und eine Größe von bis zu 10 nm aufweisen.

Schließlich betrifft die DE 199 58 473 A1 ein Verfahren zur Herstellung von Kompositschichten mit einer Plasmastrahlquelle, bei dem nanokristalline Partikel eingebettet werden können, und das mit bekannten, separat ansteuerbaren CVD- oder PVD-Verfahren kombiniert werden kann.

DE 19708402 C offenbart ein Verfahren, bei dem durch thermisches Spritzen oder physikalisches Dampfabscheiden eine Schicht, zum Beispiel auf Kolbenringe, aufgebracht wird, in der nanokristalline Partikel in einer Metallmatrix eingebettet sind.

### Darstellung der Erfindung

Der Erfindung liegt die Aufgabe zugrunde, ein Verfahren zur Beschichtung eines Gleitelements und ein entsprechendes Gleitelement zur Verfügung zu stellen, mit denen die geforderten Reibungs- und Verschleißeigenschaften über die notwendige Lebensdauer zu realisieren sind.

Die Lösung dieser Aufgabe erfolgt durch das im Anspruch 1 beschriebene Verfahren.

Demzufolge schlägt die Erfindung ein Verfahren zur zumindest einlagigen und an zumindest einer Außenfläche ausgebildeten Beschichtung eines Gleitelements, insbesondere eines Kolbenrings vor, bei dem Nanopartikel zunächst hergestellt und dann während des Beschichtungsvorganges in die Beschichtung eingebracht werden. Mit anderen Worten entstehen die Nanopartikel nicht in-situ, d. h. während des Beschichtungsvorganges, sondern sie werden separat, gewissermaßen ex-situ hergestellt und während des Beschichtungsvorganges in die Beschichtung eingebaut. Der Mechanismus, der sich hierdurch nutzen lässt und der zu verbesserten mechanischen Eigenschaften, wie zum Beispiel Ermüdungsfestigkeit, Brandspurfestigkeit, Ausbruchsfestigkeit, Bruchfestigkeit und Bruchdehnung führen, funktioniert nach derzeitigem Kenntnisstand wie folgt. Es sei noch angemerkt, dass die Erfindung hierauf nicht beschränkt ist. Die Einlagerung der beschriebenen Partikel oder Teilchen ruft lokale Kristallgitterverformungen hervor, die zu den genannten, verbesserten mechanischen Eigenschaften führen. Ferner wird eine Verbesserung des Verschleißverhaltens wegen der äußerst hohen Korngrenzendichte sowie eine erhöhte Elastizität und geringere Reibung erreicht.

Die Vorteile der eingebrachten Nanopartikel lassen sich auch bei der durchzuführenden Dispersions- oder Ausscheidungshärtung nutzen. Die bei der Beanspruchung entstehenden oder bereits vorhandenen Versetzungen können sich nämlich nicht durch die Partikel oder die Ausscheidungen hindurcharbeiten oder "-schneiden", sondern wölben sich gewissermaßen zwischen den Partikeln aus. Hierdurch bilden sich Versetzungsringe, die von den Versetzungen umgangen werden müssen. Bei diesem Umgehen ist eine höhere Energie notwendig, als wenn sich diese durch die Partikel oder Ausscheidungen "hindurch schneiden". Somit wird die Belastbarkeit erhöht. Die Erfindung nutzt ferner in vorteilhafter Weise den Effekt, dass die Fließspannung für das Wandern der Versetzungen mit abnehmendem Teilchenabstand und abnehmender Teilchengröße zunimmt. Hierdurch steigt die Materialfestigkeit. Dieser Effekt ist besonders gut mit Nanopartikeln zu erhalten. Ferner hat sich im Rahmen der Erfindung herausgestellt, dass diese aufgrund ihrer hohen Fehlstellendichte an der Oberfläche nahezu unabhängig von dem zu verstärkenden Material während des Beschichtungsprozesses eingebracht und eingebaut werden können. Hierdurch können in vorteilhafter Weise die gewünschten Ausscheidungen gebildet werden, die inkohärent, teilkohärent oder kohärent sein können und die oben beschriebenen Effekte im Hinblick auf die mechanischen Eigenschaften aufweisen. Die Herstellung der Nanopartikel ex-situ gewährleistet ferner in vorteilhafter Weise, dass der chemische und kristallographische Aufbau der Nanopartikel kontrolliert werden kann. Ferner kann durch diese Kontrolle bei der Herstellung der Nanopartikel gewährleistet werden, dass diese in der gewünschten Art und Weise während des Beschichtungsprozesses in die hierdurch wachsende Schicht eingebracht werden können.

Die Beschichtung als solche erfolgt in vorteilhafter Weise mittels bewährter PVD (physical vapor deposition) und/oder CVD (chemical vapor deposition)-Beschichtungsprozesse.

Vorteilhafte Weiterbildungen des erfindungsgemäßen Verfahrens sind in den weiteren Ansprüchen beschrieben.

Für das Basismaterial oder die Matrix der Beschichtung hat sich ein Material als besonders günstig erwiesen, das Metalloxinitride, insbesondere Nitride, und insbesondere Cr(O)N, AlN oder TiN enthält.

Bei ersten Versuchen hat sich herausgestellt, dass ein Volumenanteil der Nanopartikel von 20 % oder weniger zu guten Eigenschaften führt.

Ferner konnten gute Erfahrungen mit Nanopartikeln gemacht werden, die eine Partikelgröße(-durchmesser) von 1 bis 100 nm bevorzugt 5 bis 75 und insbesondere 5 bis 50 nm aufweisen.

Für die Nanopartikel werden Verbindungen aus der Gruppe der Oxide, Carbide und/oder Silizide mit der Zusammensetzung MeₓO_{y}, MeₓC_{y} oder MeₓSi_{y} bevorzugt. Hierbei kann es sich bei dem Metall um Chrom, Titan, Tantal, Silizium, Indium, Zinn, Aluminium, Wolfram, Vanadium oder Molybdän handeln, und/oder x kann von 1 bis 3 und/oder y kann von 1 bis 3 sein.

Im Hinblick auf die Schichtdicke haben sich besonders gute Eigenschaften bei einer Dicke der Beschichtung im Bereich von 5 bis 50 µm feststellen lassen.

Wenngleich die erfindungsgemäße Beschichtung vielseitig einsetzbar ist, wird aufgrund der bewährten Eigenschaften derzeit bevorzugt, dass das Grundmaterial, also das beschichtende Material des erfindungsgemäß zu beschichtenden Gleitelements Gusseisen oder Stahl aufweist.

Die Lösung der oben genannten Aufgabe erfolgt ferner durch das im Anspruch 8 beschriebene Gleitelement, bei dem es sich insbesondere um einen Kolbenring handelt. Die bevorzugten Ausführungsformen des erfindungsgemäßen Gleitelements entsprechen denjenigen des erfindungsgemäßen Verfahrens zu dessen Herstellung. Dies gilt in gleicher Weise für die auftretenden Vorteile, die insbesondere in einem dauerhaften, und dauerhaft die geforderten Reibungswerte und Verschleißeigenschaften aufweisenden Gleitelement liegen.

Für den bevorzugten Fall eines Kolbenrings sei erwähnt, dass als Gleitflächen eine oder mehrere Flanken, d. h. die Ober- und/oder Unterseite und/oder die Lauffläche, d. h. die äußere Zylinderfläche des Kolbenrings beschichtet sein können. Die Lauffläche kann dicker mit der erfindungsgemäßen Beschichtung mit eingelagerten, separat hergestellten Nanopartikeln beschichtet sein, als zumindest eine der Flanken. Der Übergang zwischen Lauffläche und zumindest einer Flanke kann an der Beschichtung gerundet sein, ebenso wie dieser Übergang an dem Grundmaterial des Kolbenrings gerundet sein kann. Die Beschichtung beider Flanken kann gleich dick sein. In besonderen Anwendungsfällen kann auch nur die Lauffläche beschichtet sein.

## Patentansprüche

1. Verfahren zur zumindest einlagigen und an zumindest einer Außenfläche ausgebildeten Beschichtung eines Gleitelements, insbesondere eines Kolbenrings, bei dem Nanopartikel zunächst hergestellt und dann während des Beschichtungsvorgangs, der mittels eines PVD- und/oder CVD-Verfahrens erfolgt, in die Beschichtung eingebracht werden, wobei die Beschichtung in der Matrix ein Metalloxinitrid enthaltend und mit einer Gesamtdicke von 5 bis 50 µm ausgebildet wird.

2. Verfahren nach Anspruch 1, **dadurch gekennzeichnet, dass** die Beschichtung ein Metallnitrid, insbesondere CrN, AlN oder TiN enthaltend ausgebildet wird.

3. Verfahren nach Anspruch 1 oder 2, **dadurch gekennzeichnet, dass** die Beschichtung CrON enthaltend ausgebildet wird.

4. Verfahren nach einem der Ansprüche 1 bis 3, **dadurch gekennzeichnet, dass** Nanopartikel einen Anteil von bis zu 20 Vol% der Beschichtung ausmachen.

5. Verfahren nach einem der Ansprüche 1 bis 4, **dadurch gekennzeichnet, dass** die Beschichtung derart ausgebildet wird, dass die Nanopartikel eine Größe von 1 bis 100 nm, bevorzugt 5 bis 75 nm und insbesondere 5 bis 50 nm aufweisen.

6. Verfahren nach einem der Ansprüche 1 bis 5, **dadurch gekennzeichnet, dass** die Beschichtung derart ausgebildet wird, dass die Nanopartikel aus der Gruppe der Oxide, Carbide und/oder Silizide gewählt sind, und eine oder mehrere der Verbindungen MeₓO_{y}, MeₓC_{y} und MeₓSi_{y} mit Me: Cr, Ti, Ta, Si, In, Sn, Al, W, V, Mo und/oder x=1 bis 3 und/oder Y=1 bis 3 aufweisen.

7. Verfahren nach einem der Ansprüche 1 bis 6, **dadurch gekennzeichnet, dass** die Beschichtung auf Gusseisen oder Stahl als dem Grundmaterial des Gleitelements ausgebildet wird.

8. Gleitelement, insbesondere Kolbenring, mit einer zumindest einlagigen, mittels eines PVD- und/oder CVD-Verfahrens ausgebildeten Beschichtung an zumindest einer Außenfläche, die getrennt hergestellte Nanopartikel aufweist, wobei die Beschichtung in der Matrix ein Metalloxinitrid enthält und eine Gesamtdicke von 5 bis 50 µm aufweist.

9. Gleitelement nach Anspruch 8, **dadurch gekennzeichnet, dass** die Beschichtung ein Metallnitrid, insbesondere CrN, AlN oder TiN enthält.

10. Gleitelement nach Anspruch 8 oder 9, **dadurch gekennzeichnet, dass** die Beschichtung CrON enthält.

11. Gleitelement nach einem der Ansprüche 8 bis 10, **dadurch gekennzeichnet, dass** die Nanopartikel einen Anteil von bis zu 20 Vol% der Beschichtung ausmachen.

12. Gleitelement nach einem der Ansprüche 8 bis 11, **dadurch gekennzeichnet, dass** die Nanopartikel eine Größe von 1 bis 100 nm, bevorzugt 5 bis 75 nm und insbesondere 5 bis 50 nm aufweisen.

13. Gleitelement nach einem der Ansprüche 8 bis 12, **dadurch gekennzeichnet, dass** die Nanopartikel aus der Gruppe der Oxide, Carbide und/oder Silizide gewählt sind, und eine oder mehrere der Verbindungen MeₓOy, MeₓC_{y} und MeₓSi_{y} mit Me: Cr, Ti, Ta, Si, In, Sn, Al, W, V, Mo und/oder x=1 bis 3 und/oder Y=1 bis 3 aufweisen.

14. Gleitelement nach einem der Ansprüche 8 bis 13, **dadurch gekennzeichnet, dass** das Grundmaterial des Gleitelements Gusseisen oder Stahl aufweist.

## Claims

1. Method for at least single-layer coating formed on at least one outer surface of a sliding element, in particular of a piston ring, in which nanoparticles are initially produced and then during the coating process, which is effected by means of a PVD and/or CVD method, are introduced into the coating, wherein the coating is formed containing a metal oxynitride in the matrix and with a total thickness of 5 to 50 µm.

2. Method according to claim 1, **characterised in that** the coating is formed containing a metal nitride, in particular CrN, AlN or TiN.

3. Method according to claim 1 or 2, **characterised in that** the coating is formed containing CrON.

4. Method according to one of claims 1 to 3, **characterised in that** nanoparticles account for a proportion of up to 20 volume% of the coating.

5. Method according to one of claims 1 to 4, **characterised in that** the coating is formed such that the nanoparticles have a size of 1 to 100 nm, preferably 5 to 75 nm and in particular 5 to 50 nm.

6. Method according to one of claims 1 to 5, **characterised in that** the coating is formed such that the nanoparticles are selected from the group of oxides, carbides and/or silicides, and one or more of the compounds MeₓO_{y}, MeₓC_{y} and MeₓSi_{y} with Me: Cr, Ti, Ta, Si, In, Sn, Al, W, V, Mo and/or x=1 to 3 and/or Y=1 to 3.

7. Method according to one of claims 1 to 6, **characterised in that** the coating is formed on cast iron or steel as the base material of the sliding element.

8. Sliding element, in particular piston ring, having an at least single-layer coating, formed by means of a PVD and/or CVD method on at least one outer surface which has separately produced nanoparticles, wherein the coating contains a metal oxynitride in the matrix and has a total thickness of 5 to 50 µm.

9. Sliding element according to claim 8, **characterised in that** the coating contains a metal nitride, in particular CrN, AlN or TiN.

10. Sliding element according to claim 8 or 9, **characterised in that** the coating contains CrON.

11. Sliding element according to one of claims 8 to 10, **characterised in that** the nanoparticles account for a proportion of up to 20 volume% of the coating.

12. Sliding element according to one of claims 8 to 11, **characterised in that** the nanoparticles have a size of 1 to 100 nm, preferably 5 to 75 nm and in particular 5 to 50 nm.

13. Sliding element according to one of claims 8 to 12, **characterised in that** the nanoparticles are selected from the group of oxides, carbides and/or silicides, and have one or more of the compounds MeₓO_{y}, MeₓC_{y} and MeₓSi_{y} with Me: Cr, Ti, Ta, Si, In, Sn, Al, W, V, Mo and/or x=1 to 3 and/or Y=1 to 3.

14. Sliding element according to one of claims 8 to 13, **characterised in that** the base material of the sliding element has cast iron or steel.

## Revendications

1. Procédé pour le revêtement d'au moins une couche, réalisé sur au moins une surface extérieure d'un élément glissant, en particulier d'un segment de piston, où des nanoparticules sont produites dans un premier temps avant d'être intégrées au revêtement pendant le processus d'application de celui-ci, réalisé au moyen d'un procédé de dépôt physique en phase vapeur et/ou de dépôt chimique en phase vapeur, ledit revêtement contenant un oxynitrure métallique dans la matrice et étant réalisé avec une épaisseur totale comprise entre 5 et 50 µm.

2. Procédé selon la revendication 1, **caractérisé en ce que** le revêtement est réalisé de manière à contenir un nitrure métallique, en particulier CrN, AlN ou TiN.

3. Procédé selon la revendication 1 ou 2, **caractérisé en ce que** le revêtement est réalisé de manière à contenir un nitrure métallique, en particulier CrON.

4. Procédé selon l'une des revendications 1 à 3, **caractérisé en ce que** les nanoparticules représentent une part allant jusqu'à 20 % en volume du revêtement.

5. Procédé selon l'une des revendications 1 à 4, **caractérisé en ce que** le revêtement est réalisé de telle manière que les nanoparticules présentent une grandeur comprise entre 1 et 100 nm, préférentiellement entre 5 et 75 nm et en particulier entre 5 et 50 nm.

6. Procédé selon l'une des revendications 1 à 5, **caractérisé en ce que** le revêtement est réalisé de telle manière que les nanoparticules sont sélectionnées dans le groupe des oxydes, carbures et/ou siliciures, et comportent un ou plusieurs des composés MeₓO_{y}, MeₓC_{y} et MeₓSi_{y} avec Me: Cr, Ti, Ta, Si, In, Sn, Al, W, V, Mo et/ou x=1 à 3 et/ou Y=1 à 3.

7. Procédé selon l'une des revendications 1 à 6, **caractérisé en ce que** le revêtement est exécuté sur de la fonte ou de l'acier en tant que matériau de base de l'élément glissant.

8. Elément glissant, en particulier segment de piston, comportant un revêtement d'au moins une couche, réalisé au moyen d'un procédé de dépôt physique en phase vapeur et/ou de dépôt chimique en phase vapeur sur au moins une surface extérieure, ledit revêtement comportant des nanoparticules produites séparément, ledit revêtement contenant un oxynitrure métallique dans la matrice et étant réalisé avec une épaisseur totale comprise entre 5 et 50 µm.

9. Elément glissant selon la revendication 8, **caractérisé en ce que** le revêtement un nitrure métallique, en particulier CrN, AlN ou TiN.

10. Elément glissant selon la revendication 8 ou 9, **caractérisé en ce que** le revêtement contient de l'oxynitrure CrON.

11. Elément glissant selon l'une des revendications 8 à 10, **caractérisé en ce que** les nanoparticules représentent une part allant jusqu'à 20 % en volume du revêtement.

12. Elément glissant selon l'une des revendications 8 à 11, **caractérisé en ce que** les nanoparticules présentent une grandeur comprise entre 1 et 100 nm, préférentiellement entre 5 et 75 nm et en particulier entre 5 et 50 nm.

13. Elément glissant selon l'une des revendications 8 à 12, **caractérisé en ce que** les nanoparticules sont sélectionnées dans le groupe des oxydes, carbures et/ou siliciures, et comportent un ou plusieurs des composés MeₓO_{y}, MeₓC_{y} et MeₓSi_{y} avec Me: Cr, Ti, Ta, Si, In, Sn, Al, W, V, Mo et/ou x=1 à 3 et/ou Y=1 à 3.

14. Elément glissant selon l'une des revendications 8 à 13, **caractérisé en ce que** le matériau de base de l'élément glissant comporte de la fonte ou de l'acier.
